Europäisches Patentamt

European Patent Office

Office européen des brevets

(19)

(11) Numéro de publication: **0 133 080**
**B1**

## FASCICULE DE BREVET EUROPEEN

(12)

(45) Date de publication du fascicule du brevet:
09.03.88

(51) Int. Cl.⁴: **H 03 H 7/38,** H 03 F 3/60,
H 03 H 11/28

(21) Numéro de dépôt: **84401410.0**

(22) Date de dépôt: **03.07.84**

(54) **Quadrupôle d'adaptation, indépendante de la fréquence de fonctionennement, d'une réactance, et amplificateur à ondes progressives utilisant un tel quadrupôle.**

(30) Priorité: **12.07.83 FR 8311613**

(43) Date de publication de la demande:
**13.02.85 Bulletin 85/7**

(45) Mention de la délivrance du brevet:
**09.03.88 Bulletin 88/10**

(84) Etats contractants désignés:
**DE GB IT NL SE**

(56) Documents cités:
**US - A - 3 879 689**

**WIRELESS WORLD, vol. 85, no. 1524, août 1979, pages 63-66,86, Londres, GB; G. KALANIT: "Passive notch filters - 1"**

(73) Titulaire: **THOMSON-CSF, 173, Boulevard Haussmann, F-75379 Paris Cédex 08 (FR)**

(72) Inventeur: **Kaminsky, Didier, THOMSON-CSF SCPI 173, bld Haussmann, F-75379 Paris Cedex 08 (FR)**

(74) Mandataire: **Taboureau, James et al, THOMSON-CSF SCPI 19, avenue de Messine, F-75008 Paris (FR)**

## Description

La présente invention concerne un dispositif du type quadrupôle d'adaptation résistif, à adapter une réactance de type résistance self-capacité, en série ou en parallèle, et assurant un rapport d'ondes stationnaires nul ou en tous cas très faible quelque soit la fréquence d'entrée, dans une gamme très étendue de fréquences. L'invention s'applique plus particulièrement aux hyperfréquences et la réactance adaptée est avantageusement un transistor ou un amplificateur hyperfréquences.

En hyperfréquences, l'emploi des transistors bipolaires ou à effet de champ sur l'arséniure de gallium ou matériaux III–V est de plus en plus répandu pour plusieurs raisons:

– simplicité d'emploi,
– faibles tensions d'alimentation,
– gains importants,
– très haute fréquence de coupure.

De plus, la conception d'amplificateurs hyperfréquences à très large bande, à transistors, présente un très grand intérêt, spécialement pour les matériels de communications par satellites, instrumentation, contremesures, etc. . .

Mais réaliser un amplificateur à gain plat sur une large bande nécessite de compenser la chute du gain des transistors lorsque la fréquence augmente.

Pour des largeurs de bande relativement faibles, de l'ordre de l'octave ou moins, la conception d'un tel amplificateur est basée sur les techniques de synthèse de filtres sans pertes. Pour calculer les adaptateurs d'impédance en entrée et en sortie de l'amplificateur, ces adaptateurs sont, comme les transistors ou amplificateurs, assimilables à des quadrupôles. Avec de tels quadrupôles d'adaptation, la mise en cascade de plusieurs étages d'amplification est très difficile parce que les rapports d'ondes stationnaires (ROS) d'entrée et de sortie peuvent être très grands, surtout en basse fréquence, dans la bande de fréquence. En effet, si le gain d'un transistor est diminué aux basses fréquences pour obtenir un gain plat, l'onde réfléchie qui en résulte modifie l'impédance d'entrée du transistor.

D'autre part, l'utilisation d'amplificateurs de type «blancé» permet de disposer d'un amplificateur bien adapté en ROS sur une large bande de fréquences. Dans ce cas, deux amplificateurs identiques sont placés entre des coupleurs hybrides dits «90° 3 dB». La puissance réfléchie à l'entrée et à la sortie de chacun des deux amplificateurs individuels est absorbée par la charge placée sur la sortie isolée du coupleur 90°. De faibles ROS sont donc assurés et les amplificateurs sont cascadables.

La limitation la plus importante pour un amplificateur «balancé» provient surtout du coupleur. Avec les technologies présentes, la bande d'amplification d'un étage balancé est limitée à environ 2 octaves. De plus, un étage balancé nécessite 2 fois la puissance de polarisation continue par rapport à un simple étage adapté, puisqu'il y a deux amplificateurs en parallèle.

Pour obtenir des amplificateurs à large bandes avec des étages simples adaptés, trois schémas peuvent être utilisés:
– amplificateur à contre-réaction,
– amplificateur à adaptation résistive,
– amplificateur distribué.

Mais dans ces trois cas, les ROS entrée/sortie ne sont pas très bons, gênant la mise en cascade de plusieurs étages. Dans le cas de l'amplificateur à adaptation résistive il devient même nécessaire de calculer tous les étages ensembles.

L'invention concerne donc un quadrupôle d'adaptation résistif qui:
– compense la chute de gain d'un transistor ou d'un amplificateur lorsque la fréquence augmente,
– assure un ROS en entrée et/ou en sortie, nul ou très faible dans la mesure où le schéma équivalent du transistor adapté est connu, et ceci de façon indépendante de la fréquence, dans une gamme étandue de fréquences.

Ainsi, un quadrupôle selon l'invention présente en entrée et/ou sortie une impédance pur, exempte de réactance.

Le cas d'application le plus intéressant de l'adaptateur selon l'invention est celui d'un transistor, mais un transistor étant un circuit résistance-self-capacité RLC, le quadrupôle selon l'invention s'applique également et de façon plus générale à l'adaptation d'impédance d'une réactance quelconque.

Le quadrupôle selon l'invention d'impédance d'entrée $Z_e$ et d'impédance de sortie $Z_o$ regroupe, entre une première borne d'entrée et une première borne de sortie, trois circuits d'impédances $Z_1$, $Z_2$, $Z_3$: les circuits $Z_1$ et $Z_2$ sont en série entre les deux dites bornes d'entrée/sortie, et le circuit $Z_3$ est en parallèle avec les circuit $Z_1$ et $Z_2$, entre les mêmes deux bornes d'entrée/sortie. Un quatrième circuit d'impédance $Z_4$ est connecté entre le point commun aux circuits $Z_1$ et $Z_2$, et le point commun aux seconde borne d'entrée et seconde borne de sortie. Le dispositif dont il faut adapter l'impédance constitue:
– soit le circuit d'impédance $Z_3$, placé entre les premières bornes d'entrée et de sortie, si le dispositif à adapter est de type RLC en parallèle.
– soit le circuit d'impédance $Z_4$, placé entre le point commun aux circuits $Z_1$ et $Z_2$ et le point commun aux secondes bornes d'entrée et de sortie, si le dispositif à adapter est de type RCL en série.

L'une des impédances, $Z_3$ ou $Z_4$, étant imposée comme étant celle du dispositif à adapter, les trois autres sont liées par la relation:

$$Z_o Z_2 Z_3 + Z^2_o (Z_1 + Z_2 + Z_3) = Z_1 Z_3 (Z_o + Z_2 + Z_4) + Z_2 Z_3 Z_4$$

si $Z_o = Z_e$, pour que l'adaptation en impédance soit indépendante de la fréquence et que la puissance dissipée soit sélective, de façon à éviter les ondes réfléchies aux basses fréquences de la bande de fréquence.

De façon plus précise, l'invention consiste en un quadrupôle d'adaptation, présentant une impédance d'entrée $Z_e$ entre ses deux bornes d'entrée et une impédance de sortie $Z_0$ entre ses deux bornes de sortie, comportant:

- entre une première borne d'entrée et une première borne de sortie, un premier et second circuits en série d'impédances respectives $Z_1$ et $Z_2$ et un troisième circuit d'impédance $Z_3$ en parallèle avec les deux circuits précédents,
- un quatrième circuit d'impédance $Z_4$ branché entre le point commun aux deux premiers circuits et le point commun à la seconde borne d'entrée et à la seconde borne de sortie, et caractérisé en ce que l'une au moins parmi la troisième impédance et la quatrième impédance est une réactance à adapter, les valeurs de ces quatre impédances étant liées entre elles, en sorte que le quadrupôle présente à ses bornes d'entrée/sortie une impédance pure (résistance), et une réactance nulle, indépendamment de la fréquence de fonctionnement.

L'invention sera mieux comprise par la description qui en suit, et par l'exposé de quelques cas d'applications, lesquels s'appuient sur les figures jointes en annexes et qui représentent:

- fig. 1: schéma général, en diagramme de blocs, du quadrupôle d'adaptation selon l'invention,
- fig. 2: première solution du schéma de la figure 1, dans le cas où le dispositif à adapter est du type RLC en série,
- fig. 3: courbe donnant la puissance absorbée dans le dispositif à adapter en fonction de la fréquence de résonance du schéma précédent,
- fig. 4: seconde solution du schéma de la figure 1, dans le cas où le dispositif à adapter est du type RLC en série,
- fig. 5 et 6: deux solutions du schéma de la figure 1, dans le cas où le dispositif à adapter est du type RLC en parallèle,
- fig. 7: schéma électrique, équivalent à la figure 2, d'adaptation d'entrée à un transistor à effet de champ,
- fig. 8: schéma de réalisation, hybride ou monolithique, de la figure 7,
- figures 9 à 12: schémas électriques d'adaptation de sortie à un transistor à effet de champ, selon quatre variantes de l'invention,
- fig. 13: schéma de réalisation, hybride ou monolithique, de la figure 9,
- fig. 14: schéma électrique d'un amplificateur à ondes progressives, mettant en œuvre le quadrupôle d'adaptation selon l'invention.

Des quadrupôles d'adaptation, de structures en T, en T ponté ou en Y, sont bien connus. Leurs usages sont nombreux et variés, mais, en règle générale, leur fonctionnement évolue avec la fréquence. Par exemple, un article paru dans «Wireless world», vol. 85, n° 1524 août 1979, pp 63–66, donne des schémas de quadrupôles qui, tous, constituent un filtre passe-bande, donc fonction de la fréquence dans un domaine de radiofréquence (26–38 MHz). Par ailleurs, le brevet US-A 3 879 689, délivré le 22 avril 1975, décrit un quadrupôle de correction de distorsion de phase travaillant à des fréquences (MHz) telles qu'elles permettent encore l'usage de transformateurs bobinés.

Or, l'adaptateur selon l'invention doit:
— adapter une réactance telle qu'un transistor à effet de champ,
— sans que son fonctionnement soit affecté par la fréquence qui est de l'ordre de 1 à 20 GHz.

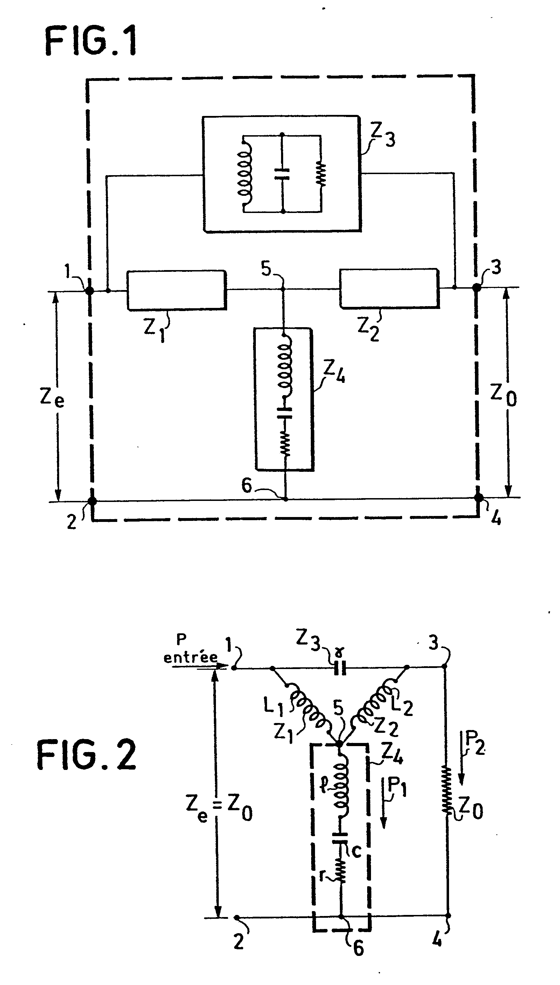

Le schéma général de l'adaptateur selon l'invention est donné sous forme de diagramme de blocs en figure 1.

Entre deux bornes d'entrée 1 et 2, entre lesquelles existe une impédance d'entrée $Z_e$, et deux bornes de sortie 3 et 4, entre lesquelles existe une impédance de sortie $Z_0$, l'adaptateur regroupe quatre impédances $Z_1$, $Z_2$, $Z_3$, $Z_4$. Les impédances $Z_1$ et $Z_2$ sont montées en série, entre les premières bornes d'entrée 1 et de sortie 3, et l'impédance $Z_3$ est montée en parallèle avec $Z_1$ et $Z_2$, entre les mêmes bornes 1 et 3. L'impédance $Z_4$ est montée entre le point 5 commun aux impédances $Z_1$ et $Z_2$ et le point 6, commun aux secondes bornes d'entrée 2 et de sortie 4.

L'adaptateur à proprement parler ne comporte que trois impédances, dont au moins $Z_1$ et $Z_2$. Le dispositif dont on veut adapter l'impédance d'entrée $Z_e$ de telle façon qu'elle soit égale à l'impédance de sortie $Z_0$ est constitué:
- soit par l'impédance $Z_3$ si le schéma équivalent dudit dispositif est un circuit résistance-self-capacité en parallèle, tel que symbolisé sur le bloc $Z_3$ de la figure 1,
- soit par l'impédance $Z_4$ si le schéma équivalent dudit dispositif est un circuit résistance-self-capacité en série, tel que symbolisé sur le bloc $Z_4$ de la figure 1.

La branche $Z_3$ ou la branche $Z_4$ étant imposée par la nature du dispositif dont il faut adapter l'impédance, les deux autres branches sont calculées: $Z_1$, $Z_2$ et $Z_4$ si $Z_3$ est imposé, $Z_1$, $Z_2$ et $Z_3$ si $Z_4$ est imposé.

Dans le cas où l'on recherche une impédance itérative, c'est-à-dire par exemple conservant la même valeur entre des différents étages d'un amplificateur, ce qui se traduit par $Z_e = Z_0$, les impédances de l'adaptateur et celle du dispositif à adapter sont liées par la relation:

$$Z_0 Z_2 Z_3 + Z^2_0 (Z_1 + Z_2 + Z_3) = Z_1 Z_3 (Z_0 + Z_2 + Z_4) + Z_2 Z_3 Z_4$$

relation qui sera par la suite désignée par «équation A». Cette relation est indépendante de la fréquence, et l'adaptateur se présente, à ses bornes d'entrée et de sortie, comme une impédance pure, exempte de réactance.

Premier cas: adaptation d'un dispositif de schéma équivalent RLC en série.

L'impédance d'un tel dispositif est donnée par la formule générale

$$Z_4 = r + j (l\omega - 1/C\omega)$$

dans laquelle r = résistance du dispositif
l = self du dispositif, par exemple celle des fils de connexion,
C = capacité du dispositif
$\omega$ = pulsation
j = constante

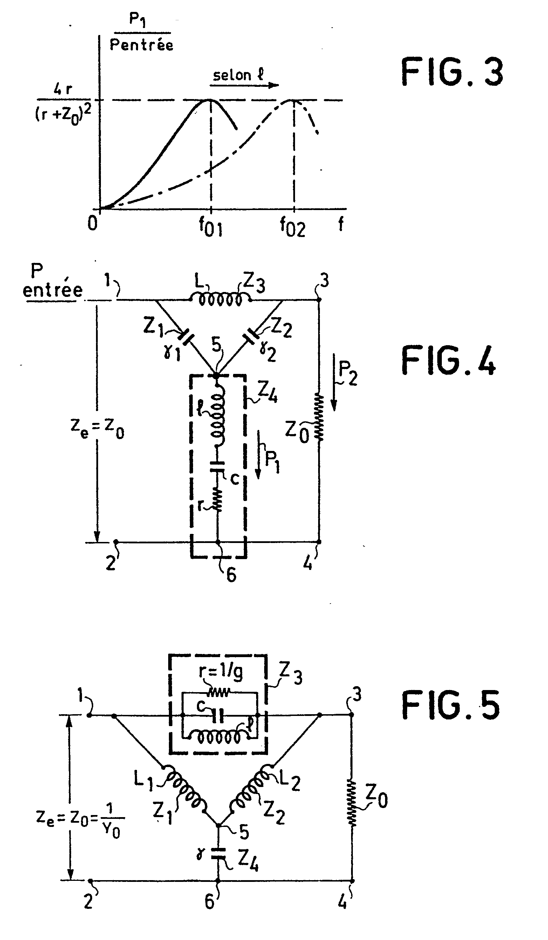

En reportant dans l'équation A et en imposant la condition que $Z_o$ soit indépendante de la fréquence d'entrée, il existe plusieurs solutions. Une solution est représentée sur la figure 2 avec la valeur des éléments fonctions de la charge $Z_4$: les composants qui constituent les impédances $Z_1$ $Z_2$ $Z_3$ ont alors les valeurs suivantes, respectivement:

$$L_1 = \frac{Z_o C}{2} (Z_o - r)$$

$$L_2 = \frac{Z_o C}{2} (Z_o + r)$$

$$\gamma = \frac{1}{C\omega_o^2 Z_o^2}$$

et la self des fils de connexions:

$$e = \frac{1}{C\omega_o^2} - \frac{(Z_o^2 - r^2)}{4} C$$

Dans ce cas, l'impédance d'entrée est constante quelque soit la fréquence et égale à $Z_o$. La puissance $P_1$ dissipée dans la résistance r du dispositif, fonction de la fréquence, très faible aux basses fréquences, augmente jusqu'à une valeur maximale pour la fréquence de résonance $f_o$ telle que

$$f_o^2 = \frac{1}{4\pi^2 \gamma (L_1 + L_2)} \quad avec \quad \frac{Pl \, max}{P \, entrée} = \frac{4 \, r \, Zo}{(r + Zo)^2}$$

valeur indépendante de la fréquence de résonance $f_o$, puis cette puissance décroît pour des fréquences supérieures à $f_o$. La valeur de la capacité $\gamma$ dépendant de la valeur de la self l du dispositif à adapter, il est possible de modifier la fréquence de résonance $f_o$ et donc de modifier la pente de la puissance absorbée dans la résistance r en changeant la valeur de cette self l. C'est ce que montre la figure 3: en modifiant la valeur de la self l, on modifie la pente de là courbe, et par conséquent la puissance absorbée par le dispositif. Le rapport d'ondes stationnaires est nul, ou très faible, indépendamment de la fréquence d'entrée. De même, à la fréquence $f_o$, le déphasage apporté par la cellule adaptatrice entre les ondes entrantes et sortantes est de 180°.

La figure 4 représente une seconde solution à ce premier cas, selon laquelle les composants qui constituent les impédances $Z_1$, $Z_2$ et $Z_3$ sont intervertis: self L au lieu de capacité $\gamma$, et capacité $\gamma_1$ et $\gamma_2$ au lieu de selfs $L_1$ et $L_2$. Ces composants sont liés par les relations:

$$\frac{1}{\gamma_1} = \frac{Z_o}{2l} (Z_o + r)$$

$$\frac{1}{\gamma_2} = \frac{Z_o}{2l} (Z_o - r)$$

$$\frac{1}{L} = \frac{Z_o^2 - r^2}{4l Z_o^2} + \frac{1}{C Z_o^2}$$

pour que $Z_e = Z_o$.

Second cas: adaptation d'un dispositif de schéma équivalent RLC en parallèle.

L'équation A peut être réécrite en admittances et se met sous la forme suivante, qui sera désignée par «équation B»:

$$Y_o Y_2 Y_4 + Y_o^2 (Y_1 + Y_2 + Y_3) = Y_1 Y_4 (Y_o + Y_2 + Y_3) + Y_2 Y_3 Y_4.$$

Cette équation B a exactement la même forme que l'équation A en permettant le rôle joué par les éléments 3 et 4, l'admittance $Y_o$ dans cette équation B correspondant à l'impédance $Z_o$ dans l'équation A.

L'admittance $Y_3$ du dispositif à adapter est donnée par la formule générale:

$$Y_3 = \frac{1}{r} + j (C\omega - 1/lu)$$

On pose $1/r = g$.

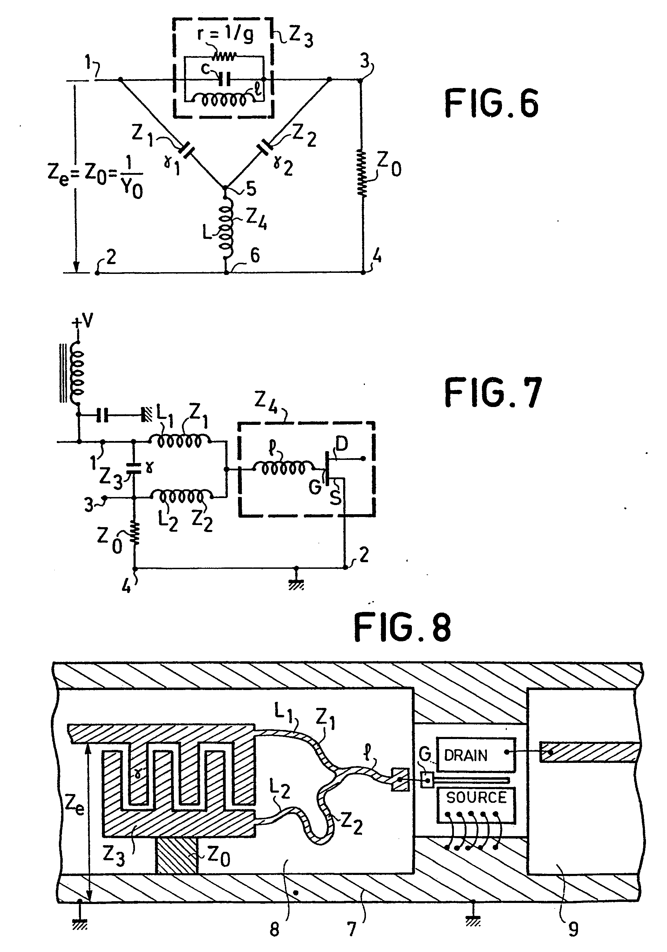

Les figures 5 et 6 représentent deux schémas d'adaptation sans limitation de fréquence, d'un dispositif dont le schéma équivalent est RLC en parallèle, qui, dans le schéma général de la figure 1, constitue l'impédance $Z_3$.

Dans le cas de la figure 5 – que l'on peut rapprocher de la figure 2 -, les impédances $Z_1$ et $Z_2$ sont constituées par deux selfs $L_1$ et $L_2$ et l'impédance $Z_4$ est constituée par une capacité $\gamma$, liées par les relations:

$$\frac{1}{L_1} = \frac{Y_o}{2C} (Y_o - g) \quad avec \, Y_o = 1/Z_o$$

$$\frac{1}{L_2} = \frac{Y_o}{2C} (Y_o + g)$$

$$\frac{1}{\gamma} = \frac{1}{Y_o^2 l} + \frac{Y_o^2 - g^2}{4C Y_o^2}$$

Dans le cas de la figure 6 - que l'on peut rapprocher de la figure 4 - les impédances $Z_1$ et $Z_2$ sont constituées par deux capacités $\gamma_1$ et $\gamma_2$ et l'impédance $Z_4$ est constituée par une self L, liées par les relations:

$$\gamma_1 = \frac{Y'_o}{2}(Y_o - g)$$

$$\gamma_2 = \frac{Y'_o}{2}(Y_o + g)$$

$$L = \frac{l(Y^2_o - g^2)}{4 Y^2_o} + \frac{C}{Y^2_o}$$

Les quatre schémas des figures 2, 4, 5 et 6 concernent des dispositifs, actifs ou passifs, qui correspondent à un schéma équivalent RLC en série ou RLC en parallèle. Les applications de ces schémas sont particulièrement intéressantes lorsque le dispositif dont il faut adapter l'impédance est un transistor.

Un premier exemple en est donné par la réalisation d'un amplificateur à transistors à effet de champ à large bande.

Il a été dit précédemment que la réalisation d'un amplificateur à gain plat sur une très large bande nécessite de compenser la chute de gain avec la fréquence. De plus, pour pouvoir mettre plusieurs étages en cascade, il faut que chaque étage soit bien adapté en impédance en entrée. L'adaptateur d'impédance selon l'invention assure à la fois les 2 fonctions:
– adaptation d'impédance quelque soit la fréquence,
– dissipation sélective de la puissance, en fonction de la fréquence.

L'impédance d'entrée d'un transistor à effet de champ sur GaAs pouvant être assimilée à un circuit RLC série, et pour des raisons de facilité de polarisation, le circuit d'adaptation de la figure 2 est celui qui est préféré pour la réalisation d'un amplificateur hybride ou intégré.

En choisissant la fréquence de résonance f o, on peut compenser la chute de gain et obtenir ainsi un gain plat sur une très grande bande passante avec un très bon coefficient de réflexion d'entrée. Les transistors à effet de champ étant en général utilisés avec la source à la masse, les bornes 2 et 4 du circuit sont prises comme masse.

La figure 7 donne le schéma électrique d'un étage d'amplificateur adapté en impédance d'entrée, selon le schéma général de la figure 2, dans lequel le transistor à effet de champ constitue l'impédance $Z_4$ équivalente à un circuit RLC en série, et les impédances $Z_1$, $Z_2$, $Z_3$ ont respectivement les valeurs $L_1$, $L_2$ et $\gamma$ définies à l'occasion de la figure 2. Un tel étage d'amplification possède un gain de 4,5 dB ± 0,5 dB entre 2 GHz et 14 GHz, grâce à l'adaptation du ROS d'entrée.

Une réalisation de cet étage en circuit microélectronique hybride ou monolithique est représenté sur la figure 8. Par rapport à un plan de masse 7 métallique, les métallisations constituant les selfs $L_1$ et $L_2$, la capacité $\gamma$ et la résistance $Z_o$ sont supportées par un substrat isolant 8, tandis que le circuit de sortie du transistor, dont la pastille est isolée par rapport au plan de masse 7, est supporté par un substrat isolant 9. Bien entendu, si l'étage d'amplification est réalisé en circuit intégré, les régions isolantes 8 et 9 sont obtenues par des techniques correspondantes: diffusion, implantation... etc. Suivant les valeurs, la capacité $\gamma$ réalisée ici en technologie interdigité peut être réalisée en structure sandwich: Metal-isolant-Metal, connue sous le nom de structure Overlay.

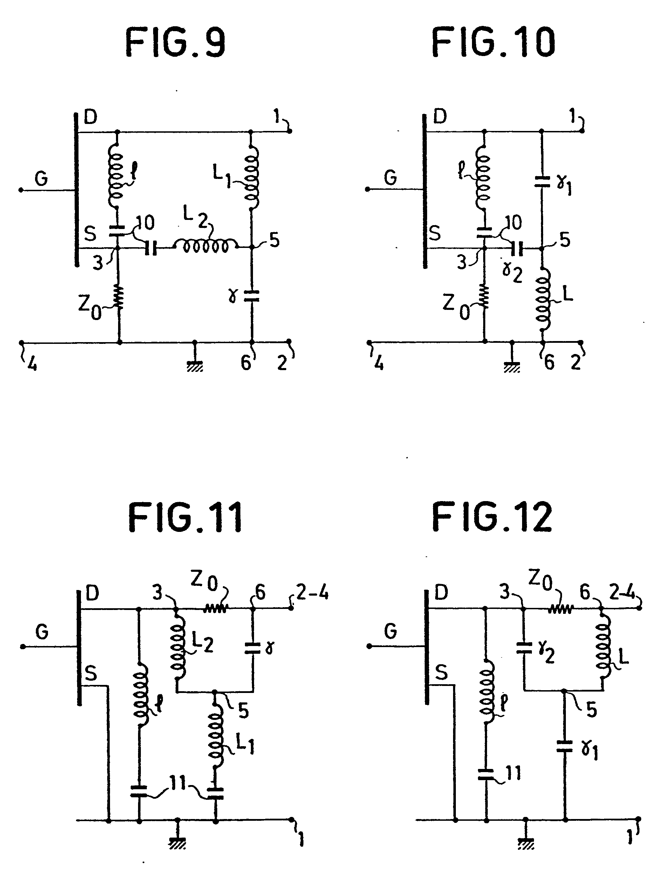

L'impédance de sortie d'un transistor bipolaire ou à effet de champ pouvant être assimilée à un circuit RLC en parallèle, l'adaptateur d'impédance selon l'invention est utilisé également pour adapter l'impédance de sortie. Dans ce cas, l'un ou l'autre des circuits d'adaptation représentés sur les figures 5 et 6 conviennent, mais, selon, que la borne 1 correspond à la source ou au drain du transistor,m cette borne 1 est alors soit la masse soit la sortie de l'adaptateur selon l'invention. Les figures 9 à 12 représentent les schémas électriques de ces quatre cas d'adaptation d'impédance de sortie.

Dans les deux cas de figures 9 et 10, correspondant respectivement aux figures 5 et 6, on a obligatoirement des selfs l en parallèle avec l'impédance drain-source, ce qui risque de court-circuiter la polarisation du transistor. Il est donc nécessaire de découpler ces selfs à l'aide de capacités en série de forte valeur, ce qui complique les circuits: ce sont la ou les capacités repérées 10. De plus, dans ces deux cas de figures 9 et 10, la source n'est plus directement à la masse et l'impédance d'entrée ne peut plus être adaptée facilement.

En ce qui concerne les schémas des figures 11 et 12, la source est à la masse et on peut découpler la self parallèle l par une capacité 11 de forte valeur à la masse, ce qui rend la polarisation très facile sur une très large bande.

Dans le cas de la figure 11, la self l, qui correspond au fil de câblage du transistor, peut même être supprimée et la polarisation s'effectuer par l'intermédiaire des deux selfs $L_1$ et $L_2$.

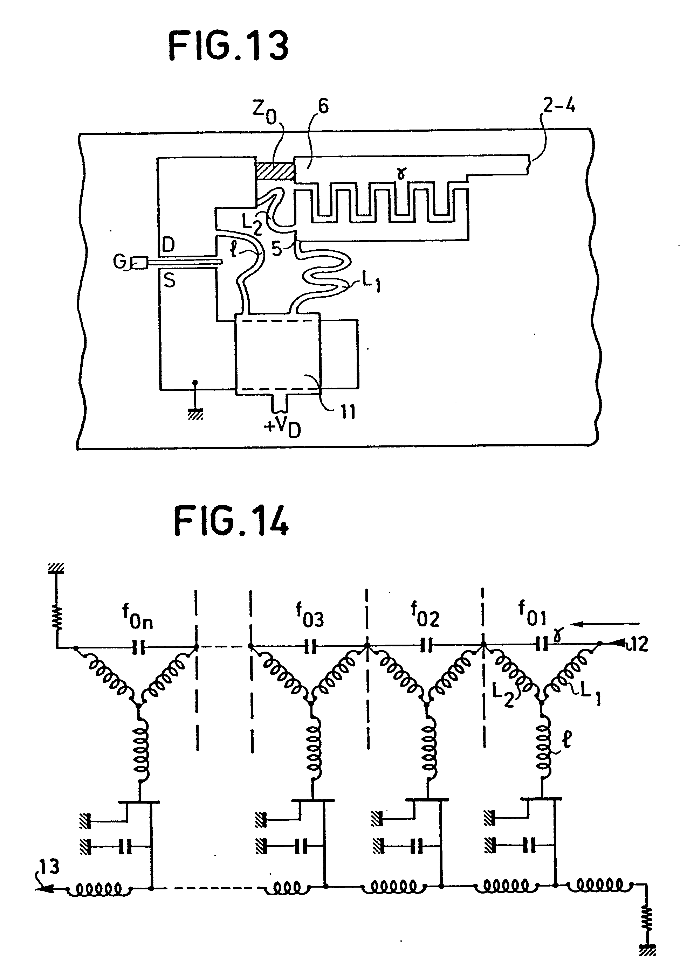

Une réalisation de la figure 11 en technique microélectronique ou en monolithique est représentée sur la figure 13. La capacité $\gamma$ est ici réalisée en métallisations interdigitées alors que les deux capacités de découplage 11 sont réalisées en structure dite overlay, métal-isolant-métal.

Un second exemple d'application de l'adaptateur d'impédance selon l'invention est donné par la figure 14: puisqu'il existe une impédance itérative, on peut générer une structure périodique, adaptée en impédance en entrée et en sortie sur la même impédance $Z_o$, grâce à l'adaptateur selon l'invention, et réaliser ainsi un amplificateur à ondes progressives. Cet amplificateur est ainsi constitué d'une pluralité de cellules montées en cascade, chaque cellule étant constituée par un quadrupôle selon l'invention, dont l'impédance de sortie $Z_o$ constitue l'impédance d'entrée $Z_e$ du quadrupôle suivant dans la cascade.

L'entrée de cet amplificateur à ondes progressives se fait sur la borne 12 et la sortie sur la borne 13. Pour chaque étage d'amplification, les valeurs $L_1$, $L_2$ et $\gamma$ des impédances de l'adaptateur selon l'invention sont calculées pour obtenir un gain plat en fonction de la fréquence.

Si toutes les fréquences de résonance $f_{oi}$, pour chaque étage, sont identiques, on obtient une structure à onde progressive «classique», la puissance appliquée à chaque transistor décroît le long de la structure.

Mais, en utilisant le fait que la fréquence de résonance de chaque cellule peut être modifiée on peut assurer, par la technique dite «tapérisation» l'égalité des puissances entrantes dans les transistors en haut de bande pour obtenir des amplificateurs de puissance. En revenant sur ce qui a été dit au sujet du graphique de la figure 3, on ajuste la puissance de chaque étage de l'amplificateur à ondes progressives en jouant sur la valeur de la self l de chaque transistor, en fonction de la valeur de la capacité $\gamma$, ce qui modifie la pente de la courbe et par voie de conséquence la puissance absorbée pour une fréquence f. Dans la figure 14, les fréquences de résonance $f_o$ sont maximales du côté de la borne d'entrée 12, et minimales du côté de la borne de sortie 13.

Un tel amplificateur à ondes progressives est préférentiellement réalisé selon le quadrupôle de la figure 2, car il permet une polarisation des transistors plus aisée qu'avec le quadrupôle de la figure 4.

L'adaptateur d'impédance selon l'invention est précisé par les revendications suivantes.

**Revendications**

1. Quadrupôle d'adaptation, présentant une impédance d'entrée $Z_e$ entre ses deux bornes d'entrée (1, 2) et une impédance de sortie $Z_o$ entre ses deux bornes de sortie (3, 4), comportant:
– entre une première borne d'entrée (1) et une première borne de sortie (3), un premier et second circuits en série d'impédances respectives $Z_1$ et $Z_2$ et un troisième circuit d'impédance $Z_3$ en parallèle avec les deux circuits précédents,
– un quatrième circuit d'impédance $Z_4$ branché entre le point commun (5) aux deux premiers circuits ($Z_1$, $Z_2$) et le point commun (6) à la seconde borne d'entrée (2) et à la seconde borne de sortie (4), et caractérisé en ce que l'une au moins parmi la troisième impédance ($Z_3$) et la quatrième impédance ($Z_4$) est une réactance à adapter, les valeurs de ces quatre impédances étant liées entre elles, en sorte que le quadrupôle présente à ses bornes d'entrée/sortie (1, 2, 3, 4) une impédance pure (résistance) ($Z_o$, $Z_e$), et une réactance nulle, indépendamment de la fréquence de fonctionnement.

2. Quadrupôle d'adaptation selon la revendication 1, caractérisé en ce que les valeurs des impédances d'entrée ($Z_e$), de sortie ($Z_o$) et du quadrupôle ($Z_1$, $Z_2$, $Z_3$, $Z_4$) son liées par la relation

$$Z_o Z_2 Z_3 + Z_o^2 (Z_1 + Z_2 + Z_3) = Z_1 Z_3 (Z_o + Z_2 + Z_4) + Z_2 Z_3 Z_4$$

pour que $Z_e = Z_o$, ces valeurs d'impédances rendant l'adaptation d'impédance du quadrupôle indépendante de la fréquence de fonctionnement.

3. Quadrupôle d'adaptation selon la revendication 1, caractérisé en ce que, la réactance à adapter étant équivalente à un circuit de type rlC, résistance-self-capacité en parallèle, elle est connectée entre la première borne d'entrée (1) et la première borne de sortie (3), à la place de l'impédance $Z_3$.

4. Quadrupôle d'adaptation selon la revendication 1, caractérisé en ce que, la réactance à adapter étant équivalente à un circuit de type rlC, résistance-self-capacité en série, elle est connectée entre le point comun (5) aux deux premier circuits ($Z_1$, $Z_2$) et le point commun (6) aux secondes bornes d'entrée (2) et de sortie (4), à la place de l'impédance $Z_4$.

5. Quadrupôle d'adaptation selon la revendication 1, caractérisé en ce que, la réactance à adapter étant équivalent à un circuit de type rlC en série, de résistance r, de self l et de capacité C, connecté à la place de l'impédance $Z_4$, le premier circuit d'impédance $Z_1$ est une self de valeur $L_1$, le second circuit d'impédance $Z_2$ est une self de valeur $L_2$, le troisième circuit d'impédance $Z_3$ est une capacité de valeur $\gamma$, ces trois valeurs étant liées par les relations

$$L_1 = \frac{Z_o C}{2} (Z_o - r)$$

$$L_2 = \frac{Z_o C}{2} (Z_o + r)$$

$$\gamma = \frac{1}{C\omega_o^2 Z_o^2}$$

$$l = \frac{1}{C\omega_o^2} - \frac{(Z_o^2 - r^2) C}{4}$$

avec $\gamma (L_1 + L_2) \omega_o^2 = 1$

$\omega$ étant la pulsation (Figure 2)

6. Quadrupôle d'adaptation selon la revendication 1, caractérisé en ce que, la réactance à adapter étant équivalente à un circuit de type rlC en série, de résistance r, de self e et de capacité C, connecté à la place de l'impédance $Z_4$, le premier circuit d'impédance $Z_1$ est une capacité de valeur $\gamma_1$, le second circuit d'impédance $Z_2$ est une capacité de valeur $\gamma_2$, le troisième circuit d'impédance $Z_3$ est une self de valeur L, ces trois valeurs étant liées par les relations

$$\frac{1}{\gamma_1} = \frac{Z_o}{2l} (Z_o + r)$$

$$\frac{1}{\gamma_2} = \frac{Z_o}{2l} (Z_o - r)$$

$$\frac{1}{L} = \frac{Z_o^2 - r^2}{4l Z_o^2} + \frac{1}{C Z_o^2}$$

(Figure 4)

7. Quadrupôle d'adaptation selon la revendication 1, caractérisé en ce que, la réactance à adapter étant équivalent à un circuit de type rlC en parallèle, de résistance r, de self l et de capacité C, connecté à la place de l'impédance $Z_3$, le premier circuit d'impédance $Z_1$ est une self de valeur $L_1$, le second circuit d'impédance $Z_2$ est une self de valeur $L_2$, la quatrième circuit d'impédance $Z_4$ est un condensateur de valeur $\gamma$, ces trois valeurs étant liées par les relations

$$\frac{1}{L_1} = \frac{Y_o}{2C}(Y_o - g)$$

$$\frac{1}{L_2} = \frac{Y_o}{2C}(Y_o + g)$$

$$\frac{1}{\gamma} = \frac{1}{Y_o^{2l}} + \frac{Y_o^2 - g^2}{4C Y_o^2}$$

avec $Y_o = 1/Z_o$ et $g = 1/r$ (Figure 5)

8. Quadrupôle d'adaptation selon la revendication 1, caractérisé en ce que, la réactance à adapter étant équivalente à un circuit de type rlC en parallèle, de résistance r, de self l et de capacité C, connecté à la place de l'impédance $Z_3$, le premier circuit d'impédance $Z_1$ est une capacité de valeur $\gamma_1$, le second circuit d'impédance $Z_2$ est une capacité de valeur $\gamma_2$, le quatrième circuit d'impédance $Z_4$ est une self de valeur L, ces trois valeurs étant liées par les relations

$$\gamma_1 = \frac{Y_o^l}{2}(Y_o - g)$$

$$\gamma_2 = \frac{Y_o^l}{2}(Y_o + g)$$

$$L = \frac{l(Y_o^2 - g^2)}{4 Y_o^2} + \frac{C}{Y_o^2}$$

avec $\gamma_o = 1/Z_o$ et $g = 1/r$ (Figure 6)

9. Amplificateur à ondes progressives, caractérisé en ce qu'il comporte une pluralité de cellules montées en cascade, chaque cellule étant constituée par un quadrupôle selon la revendication 5, l'impédance de sortie $(Z_o)$ d'une cellule constituant l'impédance d'entrée $(Z_e)$ de la cellule suivante dans la cascade, les fréquences de résonance $(f_o$ à $f_{on})$ de chaque cellule étant réglées au moyen d'une capacité $(\gamma)$ et d'une self $(l)$ en vue d'assurer l'égalité des puissances dissipées par chacune des cellules.

**Patentansprüche**

1. Anpassungsvierpol, der zwischen seinen beiden Eingangsklemmen (1, 2) eine Eingangsimpedanz $Z_e$ und zwischen seinen beiden Ausgangsklemmen (3, 4) eine Ausgangsimpedanz $Z_o$ besitzt,
- mit einem ersten und einem zweiten Kreis, die in Reihe zwischen einer ersten Eingangsklemme (1) und einer ersten Ausgangsklemme (3) angeordnet sind und eine Impedanz $Z_1$ bzw. $Z_2$ aufweisen, und mit einem dritten Kreis einer Impedanz $Z_3$, der parallel zu den beiden vorhergehenden angeschlossen ist,
- mit einem vierten Kreis einer Impedanz $Z_4$, der zwischen dem gemeinsamen Punkt (5) der beiden ersten Kreise $(Z_1, Z_2)$ und dem der zweiten Eingangsklemme (2) und der zweiten Ausgangsklemme (4) gemeinsamen Punkt (6) angeschlossen ist, dadurch gekennzeichnet, dass mindestens eine der dritten und vierten Impedanzen $(Z_3, Z_4)$ eine anzupassende Reaktanz ist, wobei die Werte der vier Impedanzen untereinander so verknüpft sind, dass der Vierpol an seinen Eingangs/Ausgangsklemmen (1, 2, 3, 4) eine rein ohm'sche Impedanz (Widerstand) $(Z_o, Z_e)$ und eine Reaktanz Null besitzt, und zwar unabhängig von der Betriebsfrequenz.

2. Anpassungsvierpol nach Anspruch 1, dadurch gekennzeichnet, dass die Werte der Eingangsimpedanz $(Z_e)$, der Ausgangsimpedanz $(Z_o)$ und des Vierpols $(Z_1, Z_2, Z_3, Z_4)$ durch die Gleichung

$$Z_o Z_2 Z_3 + Z_o^2 (Z_1 + Z_2 + Z_3) = Z_1 Z_3 (Z_o + Z_2 + Z_4) + Z_2 Z_3 Z_4$$

verknüpft sind, damit $Z_e = Z_o$ wird, wobei diese Impedanzwerte die Impedanzanpassung des Vierpols von der Betriebsfrequenz unabhängig machen.

3. Anpassungsvierpol nach Anspruch 1, dadurch gekennzeichnet, dass die anzupassende Reaktanz, falls sie einem rlC-Kreis, Widerstand-Induktivität-Kondensator in Parallelschaltung äquivalent ist, zwischen die erste Eingangsklemme (1) und die erste Ausgangsklemme (3) anstelle der Impedanz $Z_3$ eingefügt ist.

4. Anpassungsvierpol nach Anspruch 1, dadurch gekennzeichnet, dass die anzupassende Reaktanz, wenn sie einem rlC-Kreis, Widerstand-Induktivität-Kondensator in Reihe, äquivalent ist, zwischen den gemeinsamen Punkt (5) der beiden ersten Kreise $(Z_1, Z_2)$ und den der zweiten Eingangsklemme (2) und der zweiten Ausgangsklemme (4) gemeinsamen Punkt (6) anstelle der Impedanz $Z_4$ eingefügt ist.

5. Anpassungsvierpol nach Anspruch 1, dadurch gekennzeichnet, dass, wenn die anzupassende Reaktanz einem rlC-Kreis, Widerstand r, Induktivität l und Kondensator C in Reihe äquivalent ist, der anstelle der Impedanz $Z_4$ eingefügt ist, der erste Kreis der Impedanz $Z_1$ eine Induktivität des Werts $L_1$, der zweite Kreis der Impedanz $Z_2$ eine Induktivität des Werts $L_2$ und der dritte Kreis der Impedanz $Z_3$ ein Kondensator des Werts $\gamma$ ist, wobei diese drei Werte durch die folgenden Gleichungen verknüpft sind (Fig. 2):

$$L_1 = \frac{Z_o C}{2}(Z_o - r)$$

$$L_2 = \frac{Z_o C}{2}(Z_o + r)$$

$$\gamma = \frac{1}{C\omega_o^2 Z_o^2}$$

$$l = \frac{1}{C\omega_o^2} - \frac{(Z_o^2 - r^2)\,C}{4}$$

wobei $\omega$ die Kreisfrequenz ist mit

$$\gamma\,(L_1 + L_2)\,\omega_o^{\,2} = 1$$

6. Anpassungsvierpol nach Anspruch 1, dadurch gekennzeichnet, dass wenn die anzupassende Reaktanz einem rlC-Kreis, Widerstand r, Induktivität l und Kondensator C in Reihe, äquivalent ist, der anstelle der Impedanz $Z_4$ der erste Kreis der Impedanz $Z_1$ ein Kondensator des Werts $\gamma_1$, der zweite Kreis der Impedanz $Z_2$ ein Kondensator des Werts $\gamma_2$ und der dritte Kreis der Impedanz $Z_3$ eine Induktivität des Werts L ist, wobei diese drei Werte durch die folgenden Gleichungen miteinander verknüpft sind (Fig. 4):

$$\frac{1}{\gamma_1} = \frac{Z_o}{2\,l}\,(Z_o + r)$$

$$\frac{1}{\gamma_2} = \frac{Z_o}{2\,l}\,(Z_o - r)$$

$$\frac{1}{L} = \frac{Z_o^2 - r^2}{4\,l\,Z_o^2} + \frac{1}{C\,Z_o^2}$$

7. Anpassungsvierpol nach Anspruch 1, dadurch gekennzeichnet, dass, wenn die anzupassende Reaktanz einem rlC-Kreis, Widerstand r, Induktivität l und Kondensator C in Parallelschaltung, äquivalent ist, der anstelle der Impedanz $Z_3$ eingefügt ist, der erste Kreis der Impedanz $Z_1$ eine Induktivität des Werts $l_1$, der zweite Kreis der Impedanz $Z_2$ eine Induktivität des Werts $L_2$ und der vierte Kreis der Impedanz $Z_4$ ein Kondensator des Werts $\gamma$ ist, wobei diese drei Werte durch folgende Gleichungen verknüpft sind (Fig. 5):

$$\frac{1}{L_1} = \frac{Y_o}{2\,C}\,(Y_o - g)$$

$$\frac{1}{L_2} = \frac{Y_o}{2\,C}\,(Y_o + g)$$

$$\frac{1}{\gamma} = \frac{1}{Y_o^2\,l} + \frac{Y_o^2 - g^2}{4\,C\,Y_o^2}$$

mit $Y_o = 1/Z_o$ et $g = 1/r$

8. Anpassungsvierpol nach Anspruch 1, dadurch gekennzeichnet, dass, wenn die anzupassende Reaktanz einem rlC-Kreis, Widerstand r, Induktivität l und Kondensator C in Parallelschaltung äquivalent ist, der anstelle der Impedanz $Z_3$ eingefügt ist, der erste Kreis der Impedanz $Z_1$ ein Kondensator des Werts $\gamma_1$, der zweite Kreis der Impedanz $Z_2$ ein Kondensator des Werts $\gamma_2$ und der vierte Kreis der Impedanz $Z_4$ eine Induktivität des Werts L ist, wobei diese Werte durch folgende Gleichungen miteinander verbunden sind (Fig. 6):

$$\gamma_1 = \frac{Y_o^!}{2}\,(Y_o - g)$$

$$\gamma_2 = \frac{Y_o^!}{2}\,(Y_o + g)$$

$$L = \frac{l\,(Y_o^2 - g^2)}{4\,Y_o^2} + \frac{C}{Y_o^2}$$

mit $Y_o = 1/Z_o$ et $g = 1/r$

9. Wanderwellenverstärker, dadurch gekennzeichnet, dass er eine Vielzahl von in Kaskade angeordneten Zellen aufweist, wobei jede Zelle aus einem Vierpol nach Anspruch 5 besteht, und die Ausgangsimpedanz ($Z_o$) einer Zelle die Eingangsimpedanz ($Z_e$) der in der Kaskade nächstfolgenden Zelle bildet und die Resonanzfrequenzen ($f_o$ bis $f_{on}$) jeder Zelle mit Hilfe eines Kondensators ($\gamma$) und einer Induktivität (l) so eingestellt werden, dass in jeder Zelle dieselbe Leistung umgesetzt wird.

## Claims

1. A matching quadripole having an input impedance $Z_e$ between its two input terminals (1, 2) and an output impedance $Z_o$ between its two output terminals (3, 4) and comprising:
- between a first input terminal (1) and a first output terminal (3) a first circuit of an impedance $Z_1$ in series with a second circuit of an impedance $Z_2$, and, in parallel to these two circuits, a third circuit of an impedance $Z_3$,
- and a fourth circuit of an impedance $Z_4$ connected between the common point (5) of the two first circuits ($Z_1$, $Z_2$) and the point (6) common to the second input terminal (2) and the second output terminal (4), characterized in that one at least of the third and fourth impedances ($Z_3$, $Z_4$) is a reactance which should be matched, the values of these four impedances being linked such that the quadripole presents at its input/output terminals (1, 2, 3, 4) an ohmic impedance (resistor) ($Z_o$, $Z_e$) and a zero reactance, independently of the frequency of operation.

2. A matching quadripole according to claim 1, characterized in that the input and output impedances ($Z_e$, $Z_o$) and the quadripole impedances ($Z_1$, $Z_2$, $Z_3$, $Z_4$) are linked by the relation

$$Z_o\,Z_2\,Z_3 + Z_o^2\,(Z_1 + Z_2 + Z_3) =$$
$$Z_1\,Z_3\,(Z_o + Z_2 + Z_4) + Z_2\,Z_3\,Z_4$$

for $Z_e = Z_o$, these impedance values rendering the impedance matching of the quadripole independent of the frequency of operation.

3. A matching quadripole according to claim 1, characterized in that, the reactance to be matched being equivalent to a circuit of the type rlC, resistor-self-capacitor in parallel, the reactance is inserted between the first input terminal (1) and the first output terminal (3) instead of the impedance $Z_3$.

4. A matching quadripole according to claim 1, characterized in that, the reactance to be matched being equivalent to a circuit of the type rlC, resistor-self-capacitor in series, the reactance is inserted between the common point (5) the two first circuits ($Z_1$, $Z_2$) and the common point (6) of the second input terminal (2) and the second output terminal (4) instead of the impedance $Z_4$.

5. A matching quadripole according to claim 1, characterized in that, the reactance to be matched being equivalent to a circuit of the type rlC, resistor r, self l and capacitor C in series, inserted instead of the impedance $Z_4$, the first circuit of the impedance $Z_1$ is a self having the value $L_1$, the second circuit of impedance $Z_2$ is a self having the value $L_2$, the third circuit of impedance $Z_3$ is a capacitor having the value $\gamma$, the three values being linked by the relations:

$$L_1 = \frac{Z_o C}{2} (Z_o - r)$$

$$L_2 = \frac{Z_o C}{2} (Z_o + r)$$

$$\gamma = \frac{1}{C \omega_o^2 Z_o^2}$$

$$l = \frac{1}{C \omega_o^2} - \frac{(Z_o^2 - r^2) C}{4}$$

with $\gamma (L_1 + L_2) \omega_o^2 = 1$

$\omega$ being the angular frequency (fig. 2).

6. A matching quadripole according to claim 1, characterized in that the reactance to be matched being equivalent to a circuit of the type rlC, resistor r, self l and capacitor C in series, inserted instead of the impedance $Z_4$, the first circuit of impedance $Z_1$ is a capacitor having the value $\gamma_1$, the second circuit of impedance $Z_2$ is a capacitor having the value $\gamma_2$, the third circuit of impedance $Z_3$ is a self having a value L, these three values being linked by the relations (fig. 4):

$$\frac{1}{\gamma_1} = \frac{Z_o}{2l} (Z_o + r)$$

$$\frac{1}{\gamma_2} = \frac{Z_o}{2l} (Z_o - r)$$

$$\frac{1}{L} = \frac{Z_o^2 - r^2}{4 l Z_o^2} + \frac{1}{C Z_o^2}$$

7. A matching quadripole according to claim 1, characterized in that, the reactance to be matched being equivalent to a circuit of the type rlC, resistor r, self l and capacitor C in parallel, inserted instead of the impedance $Z_3$, the first circuit of the impedance $Z_1$ is a self having a value $L_1$, the second circuit of the impedance $Z_2$ is a self having a value $L_2$, the fourth circuit of impedance $Z_4$ is a capacitor having a value $\gamma$, these three values being linked by the relations (fig. 5):

$$\frac{1}{L_1} = \frac{Y_o}{2C} (Y_o - g)$$

$$\frac{1}{L_2} = \frac{Y_o}{2C} (Y_o + g)$$

$$\frac{1}{\gamma} = \frac{1}{Y_o^{2l}} + \frac{Y_o^2 - g^2}{4C Y_o^2}$$

with $Y_o = 1/Z_o$ et $g = 1/r$

8. A matching quadripole according to claim 1, characterized in that, the reactance to be matched being equivalent to a circuit of the rlC type, resistor r, self l and capacitor C in parallel, inserted instead of the impedance $Z_3$, the first circuit of impedance $Z_1$ is a capacitor having a value $\gamma_1$, the second circuit of impedance $Z_2$ is a capacitor having a value $\gamma_2$, the fourth circuit of impedance $Z_4$ is a self having a value L, these three values linked by the relations (fig. 6):

$$\gamma_1 = \frac{Y_o^l}{2} (Y_o - g)$$

$$\gamma_2 = \frac{Y_o^l}{2} (Y_o + g)$$

$$L = \frac{l (Y_o^2 - g^2)}{4 Y_o^2} + \frac{C}{Y_o^2}$$

with $Y_o = 1/Z_o$ et $g = 1/r$

9. A travelling wave amplifier, characterized in that it comprises a plurality of cells mounted in cascade, each cell being constituted by a quadripole according to claim 5, the output impedance ($Z_o$) of one cell constituting the input impedance ($Z_e$) of the next following cascade cell, the resonance frequencies ($f_o$ to $f_{on}$) of any cell being adjusted by means of a capacitor ($\gamma$) and a self (l) in order to ensure the equality of the dissipated powers in all the cells.

# FIG.1

# FIG.2

FIG. 3

FIG. 4

FIG. 5

0 133 080

FIG.6

FIG.7

FIG.8

- 15

# FIG.9

# FIG.10

# FIG.11

# FIG.12

# FIG.13

# FIG.14